Europäisches Patentamt

European Patent Office

Office européen des brevets

(19)

(11) Veröffentlichungsnummer: **0 045 403**
**B1**

(12) # EUROPÄISCHE PATENTSCHRIFT

(45) Veröffentlichungstag der Patentschrift:
06.11.85

(51) Int. Cl.⁴: **G 11 C 5/00**, G 11 C 11/40,
H 01 L 21/26

(21) Anmeldenummer: **81105464.2**

(22) Anmeldetag: **13.07.81**

(54) Verefahren zur Herstellung einer Anordnung zum Verringern der Strahlungsempfindlichkeit von in integrierter MOS-Schaltkreistechnik ausgeführten Speicherzellen.

(30) Priorität: **17.07.80 DE 3027175**

(43) Veröffentlichungstag der Anmeldung:
**10.02.82 Patentblatt 82/6**

(45) Bekanntmachung des Hinweises auf die Patenterteilung:
**06.11.85 Patentblatt 85/45**

(84) Benannte Vertragsstaaten:
**BE FR GB IT NL**

(56) Entgegenhaltungen:
**NACHRICHTENTECHNISCHE ZEITSCHRIFT, Band 26, Heft 1, Januar 1973, Seiten 9-15, Berlin, DE. K. GOSER: "Speicher kleiner Verlustleistung in P-Kanal-MOS-Technik mit Sonderprozessen und in Komplementärkanal-MOS-Technik"**
**IEEE JOURNAL OF SOLID-STATE CIRCUITS, Band 14, Nr. 5, Oktober 1979, Seiten 840-844, New York, U.S.A., J. LOHSTROH: "The punchthrough device as a passive exponential load in fast static bipolar RAM cells"**
**IEEE TRANSACTIONS ON ELECTRON DEVICES, Band ED-27, Nr.8, August 1980, Seiten 1591-1595, New York, U.S.A., O. MINATO et al.: "2K x 8 Bit Hi-CMOS Static RAM's"**

(73) Patentinhaber: **Siemens Aktiengesellschaft, Berlin und München Wittelsbacherplatz 2, D-8000 München 2 (DE)**

(72) Erfinder: **Horninger, Karlheinrich, Dr. Dipl.-Ing., Riederingerstrasse 9, D-8011 Eglharting (DE)**

## Beschreibung

Auf dem Gebiet der elektronischen Datenverarbeitung gewinnen statische Speicher wegen der ihnen eigenen einfachen Betriebsweise bzw. Handhabbarkeit und wegen der mit ihnen erzielbaren Schreib- und Lesegeschwindigkeiten zunehmend an Bedeutung. Als Speicherzelle bei solchen statischen Speichern wird ganz allgemein das an sich bekannte Flipflop benutzt. Bisher bekannte Speicherzellen der angegebenen Art wurden in aller Regel mit Lastelementen, die als Verarmungs(depletion)-Lastelemente ausgeführt sind, realisiert. Anstelle solcher Lastelemente werden jedoch neuerdings vorteilhafterweise Lastwiderstände aus Poly-Silizium verwendet. Sie bieten im wesentlichen zwei Vorteile, nämlich den Vorteil eines kleineren Flächenbedarfs je Speicherzelle (bis zu 25% Flächengewinn bei Verwendung von zwei Poly-Si-Lagen) und den Vorteil einer geringeren Verlustleistung, da der Flächenwiderstand des Poly-Si-Widerstandes höher als der des Verarmungs(depletion)-Transistors eingestellt werden kann.

Die beiden zuvor genannten Vorteile werden jedoch durch den Nachteil erkauft, dass die betreffende Speicherzelle durch das Auftreffen von $\alpha$-Teilchen an den Flipflop-Knoten durch die dabei generierten Ladungsträger leicht aus ihrem jeweiligen Schaltzustand in den jeweils anderen Schaltzustand gekippt werden kann.

Aus NTZ, Bd. 26, Heft 1, Januar 1973, S. 10 (Bild 3 u. Abschn. 2.2) ist eine Schaltung eines Speicherelementes bekannt, bei der zur Erhöhung der Störsicherheit Lastwiderstände, die mit den konstruktiv bedingten Knotenkapazitäten zusammenwirken, vorgesehen sind. Diese Elemente bestimmen gemeinsam die für die Störsicherheit des Speicherelementes, nämlich eines Flipflop, wesentliche Zeitkonstante.

Der vorliegenden Erfindung liegt die Aufgabe zugrunde, ein Verfahren zur Herstellung einer Anordnung zum Verringern der Strahlungsempfindlichkeit von Speicherzellen der genannten Art oder Logikzellen, die einen vergleichbaren oder ähnlichen inneren Aufbau haben, zu schaffen, bei denen die genannten Vorteile des Einsatzes von Poly-Silizium-Lastwiderständen anstelle von Lasttransistoren dadurch voll ausgeschöpft werden können, dass an den Flipflop-Knoten auftreffende Ladungsträger keine Änderung des jeweiligen Schaltzustandes mehr bewirken können, wobei das Verfahren auf einfache Weise zwischen Verfahrensschritten, die zur Herstellung der Speicherzellen ohnehin erforderlich sind, ausführbar sein soll und wobei das Verfahren gestattet, die Knotenkapazitäten auf eine Weise zu erhöhen, dass der Vorteil der Flächenersparnis durch Verwendung von Poly-Si-Lastelementen nicht wieder verlorengeht.

Die der Erfindung zugrunde liegende Aufgabe wird durch ein Verfahren zur Herstellung einer Anordnung zum Verringern der Strahlungsempfindlichkeit von in integrierter MOS-Schaltkreistechnik ausgeführten Speicherzellen, bei denen jeweils als speicherndes Element ein Flipflop vorgesehen ist, dessen Flipflopknoten über Poly-Silizium-Lastwiderstände an die Versorgungsspannungsklemme gelegt sind und bei denen die Strahlungsempfindlichkeit durch Erhöhen der Knotenkapazitäten mittels Implantation in das Substrat unterhalb eines der Diffusionsgebiete eines zu der betreffenden Speicherzelle gehörenden Auswahltransistors herabgesetzt wird, wobei in einer ersten Gruppe von Verfahrensschritten Feldoxidbereiche erzeugt werden und anschliessend ganzflächig das dünne Gate-Oxid, in das Löcher zur Herstellung von Kontakten zwischen dem später aufzubringenden Poly-Si und dem einkristallinen Si geätzt werden, aufgebracht wird, gelöst, das dadurch gekennzeichnet ist, dass vor dem Abscheiden erforderlicher Poly-Si1-Flächen und nach der Kontaktätzung zur Erhöhung der Knotenkapazitäten durch Implantation in das Substrat ein zwischengeschalteter Verfahrensschritt durchgeführt wird, wobei die verbliebenen Si-$O_2$-Flächen als Implantationsmaske verwendet werden.

Die Erfindung bietet den Vorteil, dass das Verfahren auf einfache Art durch sein Zwischenschalten zwischen ohnehin erforderliche Verfahrensschritte zur Herstellung der Speicherzellen ausgeführt werden kann und dass mit dem Verfahren eine Erhöhung der Knotenkapazitäten ohne zusätzlichen Flächenaufwand ermöglicht ist, wodurch zum einen die Strahlungsempfindlichkeit der Speicherzellen herabgesetzt werden kann und zum anderen der Vorteil der Flächenersparnis durch Verwendung von Poly-Si-Lastelementen erhalten bleibt.

Im folgenden wird die Erfindung an Hand mehrerer, den Stand der Technik bzw. Ausführungsbeispiele für die Erfindung betreffender Figuren im einzelnen erläutert.

Fig. 1 zeigt eine bekannte Speicherzelle mit als Verarmungs(depletion)-Typ ausgeführten Lasttransistoren $T_{LA}$, $T_{LB}$, einer Bitleitung BL, einer inversen Bitleitung $\overline{BL}$ und einer Wortleitung WL.

Fig. 2 zeigt das Schaltbild einer ebenfalls bekannten Speicherzelle, bei der die Lasttransistoren durch höherohmige Lastwiderstände $R_{LA}$, $R_{LB}$ ersetzt sind.

Fig. 3 zeigt das Schaltbild eines Ausführungsbeispiels für die vorliegende Erfindung, bei der gegenüber den bekannten Speicherzellen wesentlich vergrösserte Knotenkapazitäten $C_A$, $C_B$ vorgesehen sind.

Fig. 4 zeigt ein Ausführungsbeispiel für das Layout der erfindungsgemässen Speicherzelle mit verschiedenen Darstellungsarten für Dünnoxid (D-OX), Polysilizium 1 (Poly Si1), Polysilizium 2 (Poly Si2), Kontaktloch auf Diffusionsgebiet und Polysilizium 1 (KI-D/Poly Si1), Kontaktloch Polysilizium 1 auf Polysilizium 2 (KI-Poly Si1/2), Aluminium (Al) und AB-Kontaktloch und Maske für das erfindungsgemässe Implantationsgebiet (AB-KI/M).

Fig. 5 zeigt einen Schnitt entlang der Schnittlinie A-A' gemäss Fig. 4, aus dem u.a. neben einem Feldimplantationsgebiet FI Lage und Ausdehnung des erfindungsgemässen Implantationsgebietes I hervorgeht.

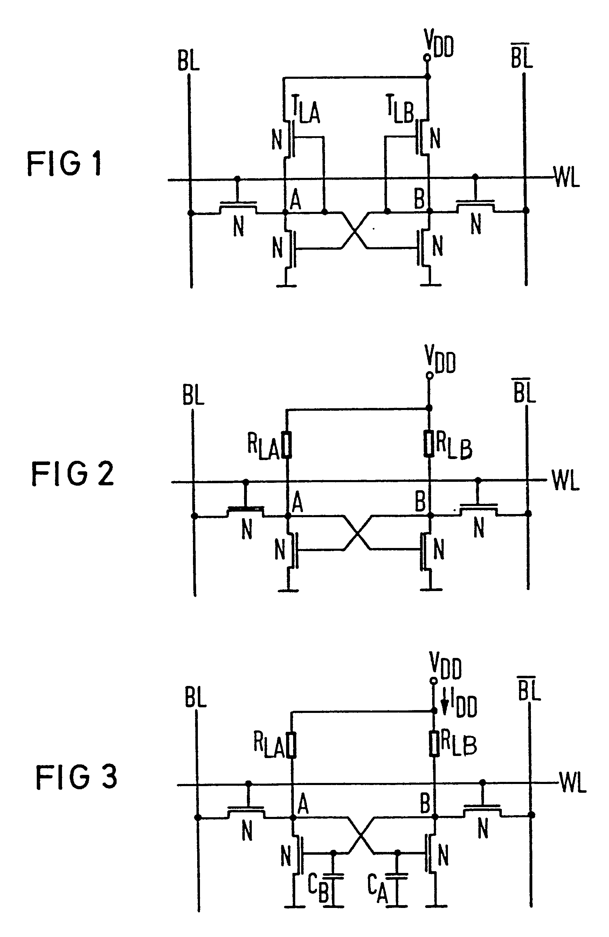

Wie bereits erläutert, zeigen die Figuren 1 und 2 bekannte Speicherzellen, wobei die Speicherzelle gemäss Fig. 1 als Lastelemente Verarmungs(depletion)-Transistoren enthält, die, wie oben erläutert, den Nachteil haben, dass ein verhältnismässig grosser Flächenbedarf besteht und darüber hinaus eine unerwünscht hohe Verlustleistung verbraucht wird.

Die in Poly-Silizium ausgeführten Lastwiderstände gemäss Fig. 2 benötigen wesentlich weniger Fläche (bis zu 25% bei Verwendung von zwei Poly-Si-Lagen) und sind verhältnismässig hochohmig, so dass eine wesentlich geringere Verlustleistung auftritt. Typische Werte für den Haltestrom $I_{DD}$ für eine Ausführung mit Verarmungs(depletion)-Typ-MOSFET liegen bie 2 bis 10 μA, wogegen diese bei Speicherzellen mit Poly-Si-Lastwiderständen bei nur 0,1 bis 1,0 μA liegen. Die genannten Vorteile werden jedoch, wie bereits oben erläutert, durch den Nachteil erkauft, dass die betreffenden Zellen durch das Auftreffen von α-Teilchen an den Flipflop-Knoten A bzw. B und die dabei entstehenden Ladungsträger leicht aus dem einen in den anderen Schaltzustand gekippt werden können. Dieser Vorgang sei an Hand eines Beispiels näher erläutert. Der Haltestrom $I_{DD}$ sei 0,25 μA, die Knotenkapazitäten $C_A$ und $C_B$ werden mit einer Kapazität von ca. 30 fF angenommen. Der Flipflop-Knoten A soll bei dem betrachteten Beispiel auf einem Potential von +5 Volg, der Flipflop-Knoten B auf einem Potential von 0 Volt liegen. Trifft nun ein α-Teilchen auf den Flipflop-Knoten B, so werden dort impulsartig für ca. 50 bis 100 Nanosekunden Ladungen generiert, die jedoch keinen Einfluss auf den Schaltzustand der Zelle haben. Trifft das α-Teilchen jedoch auf den Flipflop-Knoten A, so senken die generierten Ladungen den Flipflop-Knoten auf ein Potential von 0 volt ab, wenn diese Ladungen nicht über den betreffenden Lastwiderstand von der Versorgungsspannungsquelle abgesaugt werden können. Da der Stromimpuls des α-Teilchens ca. 2 μA beträgt, vgl. M. Geilhufe: "Soft Erros in Semiconductor Memories", Compcon 1979, Digest of Technical Papers, pp. 210–216, so kann grob abgeschätzt werden, auf welchen Wert die Flipflop-Knotenspannung am Flipflop-Knoten A mit den oben angegebenen Daten absinkt:

$$\Delta U = \Delta t.i. \frac{1}{C} = 100.10^{-9}(2.10^{-6}) - 0,25.10^{-6})$$

$$\frac{1}{30.10^{-15}} = 5.83 \, V$$

Damit wird der Flipflop-Knoten A auf ein Potential von ca. 0 Volt gezogen, womit das Flipflop in den jeweils anderen Schaltzustand kippt. Damit ist eine falsche Information gespeichert.

Erfindungsgemäss wird nun durch die zusätzliche Implantation erreicht, dass die Knotenkapazitäten $C_A$ und $C_B$ auf einen etwa 5- bis 10fachen Wert gegenüber dem oben angegebenen Wert steigen. Bei einer 5fachen Steigerung beträgt nach der einfachen Rechnung der Wert für $\Delta U$ nur mehr 1,17 Volt. Eine solche Spannung reicht nicht mehr aus, das Flipflop zu kippen. Die Erhöhung der Knotenkapazitäten $C_A$ und $C_B$ zieht keine Nachteile bezüglich der Geschwindigkeit des Einschreib- und Auslesevorgangs nach sich, vgl. Fig. 3.

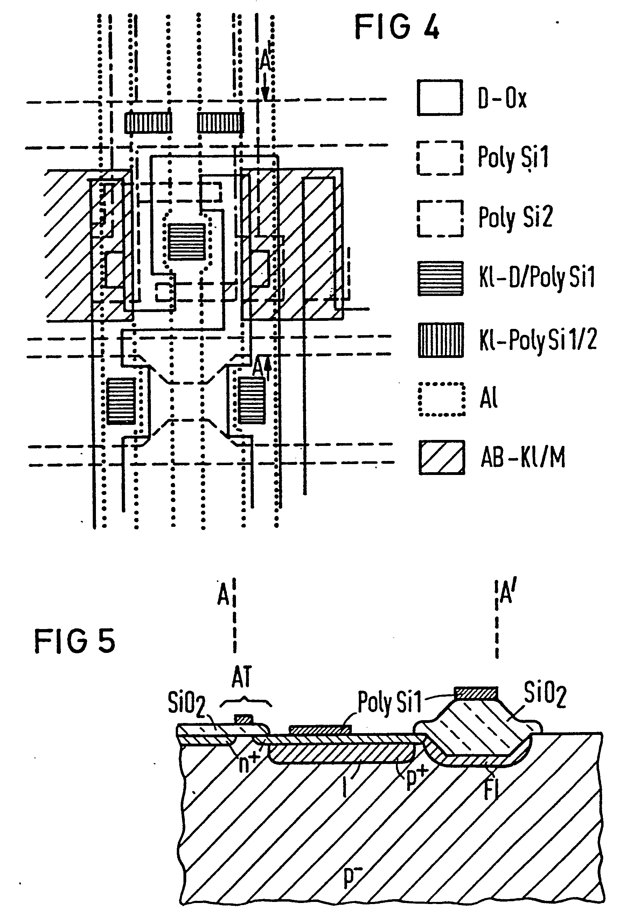

Fig. 4 zeigt, wie bereits ebenfalls erläutert, ein Ausführungsbeispiel für ein Layout einer Speicherzelle. Der schraffierte Bereich stellt die Maske für das AB-Kontaktloch, d.h. die direkte Verbindung von Poly-Silizium zum einkristallinen Grundmaterial dar. Diese Maske kann bei geeigneter Ausbildung vorteilhaft dazu verwendet werden, vor dem Abscheiden des Poly-Siliziums eine Bor-Implantation durchzuführen. Fig. 5 zeigt, wie ebenfalls bereits erläutert, einen Querschnitt entlang einer Schnittlinie A-A' gemäss Fig. 4. Das $n^+$-Diffusionsgebiet liegt gemäss der Erfindung in einer p-Wanne mit erhöhter Konzentration, beispielsweise $10^{17}$ cm$^{-3}$, und hat daher eine 5- bis 10fach höhere Kapazität gegenüber dem Fall, bei dem die Kapazität zwischen dem $n^+$-Gebiet und dem Grundmaterial mit einer Dotierung von beispielsweise $5.10^{14}$cm$^{-3}$ liegen würde. Bei anderen als der gezeigten Konfiguration kann es notwendig sein, einen andersgearteten Ausschnitt mit Bor zu implantieren. Hierzu würde allerdings eine andere Maske benötigt, die unter Umständen zusätzliche Verfahrensschritte nach sich ziehen würde.

Die erfindungsgemässe Anordnung ist vorteilhaft auch bei Logikzellen, die einen verhältnismässig hochohmigen Lastwiderstand haben, verwendbar.

**Patentanspruch**

Verfahren zur Herstellung einer Anordnung zum Verringern der Strahlungsempfindlichkeit von in integrierter MOS-Schaltkreistechnik ausgeführten Speicherzellen, bei denen jeweils als speicherndes Element ein Flipflop vorgesehen ist, dessen Flipflopknoten über Poly-Silizium-Lastwiderstände an die Versorgungsspannungsklemme gelegt sind und bei denen die Strahlungsempfindlichkeit durch Erhöhen der Knotenkapazitäten ($C_A$, $C_B$) mittels Implantation in das Substrat unterhalb eines der Diffusionsgebiete ($n^+$) eines zu der betreffenden Speicherzelle gehörenden Auswahltransistors (AT) herabgesetzt wird, wobei in einer ersten Gruppe von Verfahrensschritten Feldoxidbereiche erzeugt werden und anschliessend ganzflächig das dünne Gate-Oxid, in das Löcher zur Herstellung von Kontakten zwischen dem später aufzubringenden Poly-Si und dem einkristallinen Si geätzt werden, aufgebracht wird, dadurch gekennzeichnet, dass vor dem Abscheiden erforderlicher Poly-Si1-Flächen und nach der Kontaktätzung zur Erhöhung der Knotenkapazitäten ($C_A$, $C_B$) durch Implantation in das Substrat ein zwischengeschalteter Verfahrensschritt durchgeführt wird, wobei die verbliebenen Si-O$_2$-Flächen als Implantations-maske verwendet werden.

## Claim

A method of producing an arrangement for reducing the sensitivity to radiation of integrated circuit MOS memory cells, in which a flip-flop is in each case provided as a memory element, the flip-flop nodes of which are connected by way of polysilicon load resistances to the supply voltage terminal, and in which the radiation sensitivity is reduced by increasing the node capacitances ($C_A$, $C_B$) by implantation into the substrate beneath one of the diffusion zones (n$^+$) of a selector transistor (AT) assigned to the memory cell in question, wherein field oxide zones are produced in a first group of process steps, whereupon the thin gate oxide, into which holes are etched for the production of contacts between the polysilicon (which is to be applied subsequently) and the monocrystalline silicon, is applied over the entire surface, characterised in that, prior to the deposition of the required polysilicon areas and after contact-etching to increase the node capacitances ($C_A$, $C_B$) by implantation into the substrate, an intermediate process step is carried out in which the remaining SiO$_2$ areas are used as an implantation mask.

## Revendication

Procédé pour fabriquer un dispositif destiné à réduire la sensibilité au rayonnement de cellules de mémoire réalisées selon la technique des circuits intégrés MOS et dans lesquelles il est prévu respectivement comme élément de mémoire une bascule bistable dont les noeuds sont raccordés par l'intermédiaire de résistances de charge en polysilicium à la borne d'alimentation en tension et dans lesquelles la sensibilité au rayonnement est réduite grâce à l'accroissement des capacités des noeuds ($C_A$, $C_B$) au moyen d'une implantation dans le substrat au-dessous de l'une des régions de diffusion (n$^+$) d'un transistor de selection (AT) appartenant à la cellule de mémoire concernée, et selon lequel, au cours d'un premier groupe de phases opératoires, on fabrique des régions d'oxyde de champ et ensuite, sur toute la surface, la couche d'oxyde mince dans laquelle on aménage par attaque chimique des trous servant à réaliser des contacts entre le polysilicium devant être déposé ultérieurement et le silicium mono-cristallin, caractérisé par le fait qu'avant le dépôt de surfaces de polysilicium nécessaires et après l'aménagement des contacts par attaque chimique, en vue d'accroître les capacités des noeuds ($C_A$, $C_B$) par implantation dans le substrat, on met en oeuvre une phase opératoire intercalaire en utilisant les surfaces de SiO$_2$ subsistantes en tant que masque d'implantation.

FIG 1

FIG 2

FIG 3

# FIG 4

| | |
|---|---|
| ☐ | D‑Ox |
| ☐ | Poly Si1 |
| ☐ | Poly Si2 |
| ▤ | Kl‑D/Poly Si1 |
| ▥ | Kl‑Poly Si 1/2 |
| ⋯ | Al |
| ▨ | AB‑Kl/M |

# FIG 5

SiO₂    AT    Poly Si1    SiO₂

n+   l   p+   Fi

p⁻